# FASCICULE DE BREVET EUROPEEN

(11) **EP 3 836 218 B1**
(45) Date de publication et mention de la délivrance du brevet: **22.05.2024**
(21) Numéro de dépôt: 20213408.6
(22) Date de dépôt: 11.12.2020
(51) Int. Cl.: H10K 30/30, H10K 30/35, H10K 30/40, H10K 85/50

(54) **COUCHE COMPOSITE PEROVSKITE/MATERIAU DE TYPE P OU DE TYPE N DANS UN DISPOSITIF PHOTOVOLTAÏQUE**
VERBUNDSCHICHT AUS PEROWSKIT/MATERIAL VOM TYP P ODER TYP N IN EINER FOTOVOLTAIKVORRICHTUNG
COMPOSITE PEROVSKITE/P-TYPE OR N-TYPE MATERIAL LAYER IN A PHOTOVOLTAIC DEVICE

(30) Priorité: 12.12.2019 FR 1914234
(43) Date de publication de la demande: 16.06.2021
(73) Titulaire: Commissariat à l'Energie Atomique et aux Energies Alternatives, 75015 Paris (FR)
(72) Inventeur: MANCEAU, Matthieu, 38054 GRENOBLE CEDEX 09 (FR); LEMAITRE, Noëlla, 38054 GRENOBLE CEDEX 09 (FR)
(74) Mandataire: Cabinet Nony

(56) Documents cités:
- WO-A1-2017/121984
- FR-A1- 3 115 929
- GB-A- 2 559 800
- US-A1- 2018 212 175
- FABIAN C. HANUSCH ET AL: "Efficient Planar Heterojunction Perovskite Solar Cells Based on Formamidinium Lead Bromide", JOURNAL OF PHYSICAL CHEMISTRY LETTERS, vol. 5, no. 16, 4 août 2014 (2014-08-04), pages 2791-2795, XP055434111, US ISSN: 1948-7185, DOI: 10.1021/jz501237m
- YUCHUAN SHAO ET AL: "Origin and elimination of photocurrent hysteresis by fullerene passivation in CH3NH3PbI3 planar heterojunction solar cells", NATURE COMMUNICATIONS, vol. 5, no. 1, 1 décembre 2014 (2014-12-01), XP055711994, DOI: 10.1038/ncomms6784
- LEE KUN-MU ET AL: "Selection of anti-solvent and optimization of dropping volume for the preparation of large area sub-module perovskite solar cells", SOLAR ENERGY MATERIALS AND SOLAR CELLS, ELSEVIER SCIENCE PUBLISHERS, AMSTERDAM, NL, vol. 172, 19 août 2017 (2017-08-19), pages 368-375, XP085185406, ISSN: 0927-0248, DOI: 10.1016/J.SOLMAT.2017.08.010
- JENA AJAY KUMAR ET AL: "Halide Perovskite Photovoltaics: Background, Status, and Future Prospects", CHEMICAL REVIEWS, vol. 119, no. 5, 1 mars 2019 (2019-03-01), pages 3036-3103, XP055799700, US ISSN: 0009-2665, DOI: 10.1021/acs.chemrev.8b00539
- WALI QAMAR ET AL: "Tandem perovskite solar cells", RENEWABLE AND SUSTAINABLE ENERGY REVIEWS, vol. 84, 1 mars 2018 (2018-03-01), pages 89-110, XP055799704, US ISSN: 1364-0321, DOI: 10.1016/j.rser.2018.01.005
- KAI YAO ET AL: "Fullerene-Anchored Core-Shell ZnO Nanoparticles for Efficient and Stable Dual-Sensitized Perovskite Solar Cells", JOULE, vol. 3, no. 2, 1 février 2019 (2019-02-01) , pages 417-431, XP055711886, ISSN: 2542-4351, DOI: 10.1016/j.joule.2018.10.018
- YOUSHENG WANG ET AL: "Air-stable, hole-conductor-free high photocurrent perovskite solar cells with CH3NH3PbI3-NiO nanoparticles composite", NANO ENERGY, vol. 27, 1 septembre 2016 (2016-09-01), pages 535-544, XP055711985, ISSN: 2211-2855, DOI: 10.1016/j.nanoen.2016.08.006
- QIFAN XUE ET AL: "Metallohalide perovskite-polymer composite film for hybrid planar heterojunction solar cells", RSC ADV., vol. 5, no. 1, 25 novembre 2014 (2014-11-25), pages 775-783, XP055354325, DOI: 10.1039/C4RA11739E
- WEI CHEN ET AL: "Low Cost and Solution Processed Interfacial Layer Based on Poly(2-ethyl-2-oxazoline) Nanodots for Inverted Perovskite Solar Cells", CHEMISTRY OF MATERIALS, vol. 28, no. 14, 8 juillet 2016 (2016-07-08), pages 4879-4883, XP055712023, ISSN: 0897-4756, DOI: 10.1021/acs.chemmater.6b00964
- YAOWEN LI ET AL: "Multifunctional Fullerene Derivative for Interface Engineering in Perovskite Solar Cells", JOURNAL OF THE AMERICAN CHEMICAL SOCIETY, vol. 137, no. 49, 4 décembre 2015 (2015-12-04), pages 15540-15547, XP055712019, US ISSN: 0002-7863, DOI: 10.1021/jacs.5b10614
- SOFIA MASI ET AL: "Growing perovskite into polymers for easy-processable optoelectronic devices", SCIENTIFIC REPORTS, vol. 5, 12 janvier 2015 (2015-01-12), page 7725, XP055354326, DOI: 10.1038/srep07725

## Description

### Domaine technique

La présente invention se rapporte au domaine des dispositifs photovoltaïques, en particulier des cellules photovoltaïques à base de matériaux de type pérovskite. Elle vise plus particulièrement à proposer la formulation d'une couche composite, dans les empilements multicouches utiles pour former ces dispositifs photovoltaïques, intégrant un matériau de type pérovskite et un matériau semi-conducteur, de type P dans le cas d'une structure NIP et de type N dans le cas d'une structure PIN, tout en conservant les performances souhaitées en termes de rendement de conversion photovoltaïque.

### Technique antérieure

Les dispositifs photovoltaïques, et en particulier les cellules photovoltaïques, comprennent un empilement multicouche comportant une couche photo-active, dite couche « active ». Cette couche active est au contact de part et d'autre avec une couche semi-conductrice de type N et une couche semi-conductrice de type P. Ce type d'ensemble multicouche, comprenant la superposition de la couche active et des deux couches de type P et de type N décrites ci-dessus est classiquement dénommé « NIP » ou « PIN » suivant l'ordre d'empilement des différentes couches sur le substrat. Dans les cellules photovoltaïques dites de type pérovskite, la couche active est constituée d'un matériau de type pérovskite halogénée, pouvant être hybride organique-inorganique ou purement inorganique.

Par exemple, une cellule photovoltaïque de type pérovskite de structure NIP comporte une structure multicouche comprenant typiquement, dans cet ordre d'empilement, un substrat transparent, une première électrode transparente également appelée électrode inférieure, une couche semi-conductrice de type N, une couche active de type pérovskite, une couche semi-conductrice de type P et une seconde électrode, également appelée électrode supérieure (pouvant être en métal, par exemple en argent ou en or).

Dans ce type de cellule photovoltaïque pérovskite, la couche semi-conductrice de type N est généralement constituée d'un oxyde semi-conducteur de type N, par exemple ZnO, AZO (oxyde de zinc dopé à l'aluminium), SnO₂ ou TiOₓ (x<2). Cette couche peut être sous forme dite mésoporeuse ou planaire. La couche semi-conductrice de type P est quant à elle constituée, dans la majorité des cas, d'un matériau organique semi-conducteur qui peut être un polymère π-conjugué, à l'image par exemple du poly(3-hexylthiophène) ou P3HT, ou encore une petite molécule comme le Spiro-MeOTAD (2,2',7,7'-Tetrakis[N,N-di(4-methoxyphenyl)amino]-9,9'-spirobifluorene).

A l'heure actuelle, les dispositifs sont typiquement réalisés par dépôts successifs des couches les unes après les autres. Dans le cas où ces dépôts sont réalisés en voie solvant, par exemple par enduction centrifuge (plus connue sous la terminologie anglo-saxonne « spin-coating »), se pose le problème du choix du ou des solvants à mettre en oeuvre, pour éviter que la couche déposée n'entraîne de dégradation de la couche sous-jacente.

Le problème se pose plus particulièrement pour le dépôt de la couche semi-conductrice supérieure, de type P dans le cas d'une structure de type NIP, et de type N dans le cas d'une structure PIN, en surface de la pérovskite. La couche semi-conductrice supérieure est ainsi généralement formée à partir d'une solution ou d'une dispersion du ou desdits matériaux semi-conducteurs dans un ou plusieurs solvant(s) apolaire(s), afin de ne pas endommager la pérovskite, soluble dans les solvants polaires. L'adhésion entre la pérovskite et la couche semi-conductrice sus-jacente ainsi formée est donc particulièrement faible, ce qui peut poser des problèmes en termes de stabilité, notamment de stabilité mécanique, de la structure ainsi formée.

FABIAN C. HANUSCH ET AL: "Efficient Planar Heterojunction Perovskite Solar Cells Based on Formamidinium Lead Bromide", JOURNAL OF PHYSICAL CHEMISTRY LETTERS, vol. 5, no. 16, 2014-08-04, pages 2791-2795, divulgue un dispositif photovoltaïque comprenant un empilement multicouche, qui contient une couche rugueuse de pérovskite.

YUCHUAN SHAO ET AL: "Origin and élimination of photocurrent hystérésis by fullerene passivation in CH3NH3PbI3 planar heterojunction solar cells", NATURE COMMUNICATIONS, vol. 5, no. 1, 2014-12-01, divulgue un dispositif photovoltaïque comprenant un empilement multicouche, qui contient une couche de pérovskite passivée avec des fullerènes.

WO 2017/121984 A1 divulgue a matériau composite polymère photoactif-pérovskite destiné à être utilisé avec des dispositifs optoélectroniques photosensibles et en particulier des cellules photovoltaïques pour convertir la lumière du soleil en électricité.

YOUSHENG WANG ET AL: "Air-stable, hole-conductor-free high photocurrent perovskite solar cells with CH3NH3PbI3-NiO nanoparticles composite", NANO ENERGY, vol. 27, 2016-09-01, pages 535-544, divulgue un dispositif photovoltaïque comprenant un empilement multicouche, qui contient une couche composite de pérovskite et oxyde de nickel.

QIFAN XUE ET AL: "Metallohalide perovskite-polymer composite film for hybrid planar heterojunction solar cells", RSC ADV., vol. 5, no. 1, 25 novembre 2014 (2014-11-25), pages 775-783, divulgue un dispositif photovoltaïque comprenant un empilement multicouche, qui contient une couche composite de pérovskite et polymère.

### Résumé de l'invention

La présente invention vise précisément à proposer une nouvelle structure d'empilement multicouche, de structure NIP ou PIN, utile pour former un dispositif photovoltaïque, permettant de s'affranchir des problèmes précités, en termes de compatibilité de la formulation mise en oeuvre pour former la couche semi-conductrice supérieure avec une couche active sous-jacente de type pérovskite.

Les inventeurs ont ainsi montré qu'il est possible de réaliser des dispositifs photovoltaïques, notamment des cellules photovoltaïques de type pérovskite, présentant d'excellentes performances, à partir d'un empilement multicouche intégrant, en surface de la couche semi-conductrice inférieure, de type N dans le cas de l'élaboration d'une structure NIP et de type P dans le cas de l'élaboration d'une structure PIN, une couche composite, combinant le matériau pérovskite et le matériau de la couche semi-conductrice supérieure, de type P dans le cas d'une structure NIP et de type N dans le cas d'une structure PIN. L'invention est telle que définie dans les revendications 1 et 8.

La présente invention concerne, selon un premier de ses aspects, un empilement multicouche, utile pour former un dispositif photovoltaïque, de structure NIP ou PIN, ledit empilement comportant au moins :
- une couche semi-conductrice, dite couche semi-conductrice inférieure, de type N dans le cas d'une structure NIP, ou de type P dans le cas d'une structure PIN ; et
- une couche composite, superposée à ladite couche semi-conductrice inférieure, comprenant au moins un matériau pérovskite et au moins un matériau de type P dans le cas d'une structure NIP ou de type N dans le cas d'une structure PIN, et présentant un gradient du ratio massique matériau P/matériau pérovskite dans le cas d'une structure NIP ou matériau N/matériau pérovskite dans le cas d'une structure PIN, dans le sens de l'interface entre ladite couche composite et ladite couche semi-conductrice inférieure vers la face opposée de ladite couche composite.

La couche composite présente ainsi une distribution inhomogène des matériaux pérovskite et de type P (ou de type N). La distribution des matériaux pérovskite et de type P (ou de type N) est telle que le ratio massique matériau pérovskite/matériau P dans le cas d'une structure NIP ou matériau pérovskite/matériau N dans le cas d'une structure PIN est plus élevé au voisinage de l'interface de ladite couche composite avec la couche semi-conductrice sous-jacente et moins élevé au voisinage de la face opposée de ladite couche composite.

Le matériau pérovskite et le matériau de type P (ou de type N) forment au sein de la couche composite selon l'invention, sur une épaisseur d'au moins 10 nm, en particulier sur une épaisseur de 10 à 150 nm, une structure interpénétrée.

Cette structure interpénétrée est identifiable par analyse par spectrométrie de masse d'ions secondaires à temps de vol (ToF-SIMS pour l'appellation anglo-saxonne « Time-of-Flight Secondary Ion Mass Spectrometry »). Cette structure interpénétrée est composée de domaines de pérovskite cristallisée incorporés dans une matrice à base du ou desdits matériaux de type P (ou de type N).

Ladite couche composite étant formée par dépôt successif desdits matériaux pérovskite et de type P ou de type N, par voie humide, avant cristallisation de la pérovskite.

Ledit empilement présentant une architecture planaire.

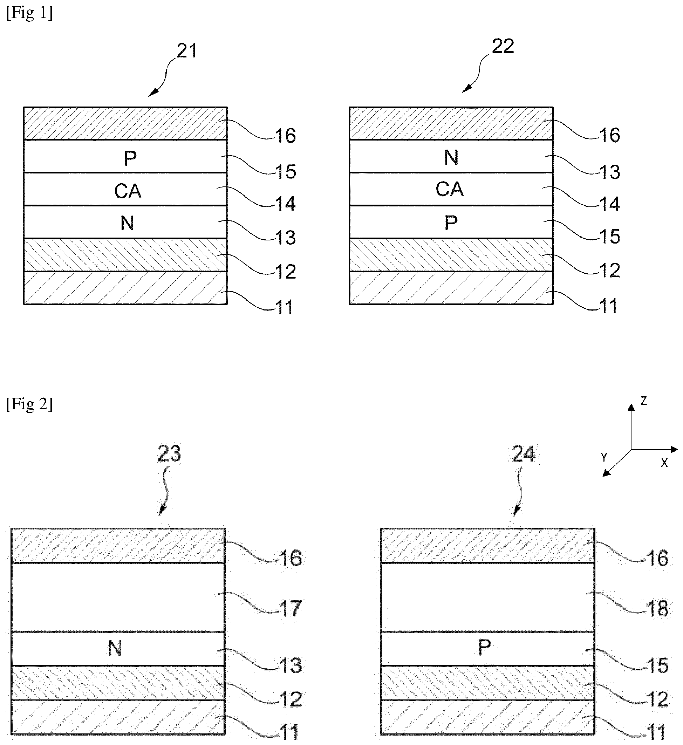

L'empilement multicouche selon l'invention peut être caractérisé dans un repère orthogonal (X,Y,Z), comme représenté en figure 2. La direction Z est la direction verticale d'empilement des couches. Les directions X et Y définissent un plan horizontal. Les couches de l'empilement multicouche selon l'invention, et en particulier la couche composite selon l'invention, s'étendent ainsi horizontalement parallèlement aux directions X et Y orthogonales.

La couche composite s'étend en particulier sur toute la surface, définie dans le plan (X,Y), perpendiculaire à la direction d'empilement (Z), de la couche semi-conductrice sous-jacente, de type N ou de type P.

Plus particulièrement, au sein de la couche composite selon l'invention, la zone interpénétrée, comprenant le mélange du matériau pérovskite et du matériau de type P (ou de type N), s'étend sur toute la surface de la couche composite définie dans le plan (X,Y), perpendiculaire à la direction Z d'empilement.

Autrement dit, la zone interpénétrée au sein d'une couche composite selon l'invention n'est nullement localisée en des zones spécifiques dans le plan (X,Y), perpendiculaire à la direction d'empilement (Z).

Ladite couche composite pérovskite/matériau P (ou matériau N) telle que définie ci-dessus sera désignée plus simplement dans la suite du texte sous l'appellation « couche composite ». Un empilement multicouche selon l'invention présente une architecture dite « planaire ». Par architecture « planaire », on entend signifier que chacune des couches de l'empilement multicouche selon l'invention est compacte. En particulier, un empilement multicouche selon l'invention diffère des structures à architecture dite « mésoporeuse », comme présenté par exemple dans la publication Rong *et al.* [1]. Les architectures dites « mésoporeuses » mettent en oeuvre une couche mésoporeuse au sein de laquelle la pérovskite est partiellement infiltrée. D'une manière générale, dans ce type de structure, la pérovskite est interpénétrée avec la couche semi-conductrice inférieure, de type N dans le cas d'une structure NIP ou de type P dans le cas d'un structure PIN.

Ainsi, avantageusement, l'empilement multicouche de structure NIP ou PIN selon l'invention ne met pas en oeuvre de couche à base d'un matériau mésoporeux.

En particulier, l'interface entre la couche composite selon l'invention et la couche semi-conductrice sous-jacente est une planaire.

Comme illustré dans l'exemple qui suit, une couche composite selon l'invention conduit à des performances de la cellule photovoltaïque, notamment en termes de rendement de conversion photovoltaïque, similaires à celles pouvant être obtenues *via* la mise en oeuvre de couches superposées distinctes couche active/couche de type P (ou de type N).

De manière avantageuse, la préparation d'un empilement multicouche selon l'invention permet de s'affranchir des problèmes de compatibilité, rencontrés lors de la formation des empilements multicouches conventionnels à architecture planaire, entre la formulation mise en oeuvre pour la formation de la couche semi-conductrice supérieure et la couche active cristallisée pérovskite sous-jacente, et du risque de détérioration de cette dernière.

Selon un autre de ses aspects, l'invention concerne un procédé de préparation d'un empilement multicouche selon l'invention, telle que définie dans la revendication 1, comprenant au moins les étapes consécutives suivantes :
(a) disposer d'une structure présentant, en surface, une couche semi-conductrice de type N, dans le cas de la formation d'un empilement de structure NIP, ou de type P dans le cas de la formation d'un empilement de structure PIN,
(b) former, en surface de ladite couche semi-conductrice de type N ou de type P, un film humide à partir d'une solution de précurseurs du matériau pérovskite dans un ou plusieurs solvants ;
(c) ajouter audit film humide de l'étape (b) au moins un matériau de type P dans le cas de la formation d'un empilement NIP, et de type N dans le cas d'un empilement PIN ; et
(d) soumettre l'ensemble à un traitement thermique propice à l'élimination des solvants et à la cristallisation du matériau pérovskite.

De manière avantageuse, la couche composite selon l'invention est formée par voie humide et, de préférence, comprend, en étape (c), le dépôt, en surface dudit film humide de l'étape (b), d'une formulation d'au moins un matériau de type P dans le cas de la formation d'un empilement NIP, dite encore « encre de type P » (ou de type N dans le cas de la formation d'un empilement PIN, dite encore « encre de type N »), dans un ou plusieurs solvants, dits « anti-solvants », dans lesquels les précurseurs de pérovskite ne sont pas solubles.

Selon un mode de réalisation particulier, comme détaillé plus précisément dans la suite du texte, les étapes (b) et (c) peuvent être réalisées par voie solvant, plus particulièrement par dépôt à la tournette ou enduction centrifuge, plus connue sous l'appellation anglo-saxonne « spin-coating ».

De manière avantageuse, le dépôt de l'encre de type P ou de type N en étape (c) du procédé de l'invention, de préférence par spin-coating, opère simultanément le « quenching » de la pérovskite.

Comme présenté par exemple dans la publication Xiao *et al.* [2], dans le cadre de la préparation d'une couche active pérovskite, la méthode connue sous l'appellation « solvent quenching » consiste plus particulièrement à déposer (ou égoutter) sur le film humide de précurseurs de la couche active pérovskite, pendant le spin-coating, une quantité d'anti-solvant, par exemple de toluène et de chlorobenzène, pour induire une cristallisation rapide de la pérovskite. L'ajout d'un anti-solvant, en réduisant rapidement la solubilité des précurseurs de pérovskite dans le milieu solvant, permet avantageusement de promouvoir une nucléation et une croissance rapide des cristaux de pérovskite. Il a été montré qu'une telle opération de « quenching » permet avantageusement d'améliorer la cristallinité du matériau pérovskite, à l'issue du recuit thermique, et ainsi la qualité de la couche active pérovskite résultante.

Ainsi, l'invention propose une méthode simplifiée pour réaliser un empilement multicouche pour des dispositifs photovoltaïques, dans laquelle les étapes de « solvent quenching » de la pérovskite et de formation de la couche semi-conductrice supérieure sont avantageusement combinées avant de procéder à la cristallisation de la pérovskite. Le procédé de l'invention permet ainsi de réduire le nombre d'étapes nécessaires à la préparation de l'empilement multicouche.

Comme détaillé dans la suite du texte, un empilement multicouche selon l'invention peut être destiné à des dispositifs photovoltaïques pérovskites, notamment des cellules photovoltaïques simple jonction, en structure dite de type « PIN » ou « NIP », ou encore des cellules photovoltaïques de type multijonction, en particulier de type tandem.

L'invention concerne ainsi, selon un autre de ses aspects, un dispositif photovoltaïque, en particulier une cellule photovoltaïque de type pérovskite, comportant un empilement multicouche tel que défini précédemment ou obtenu par un procédé tel que défini précédemment.

D'autres caractéristiques, variantes et avantages d'une couche composite selon l'invention, et de sa préparation, ressortiront mieux à la lecture de la description, des exemples et figures qui vont suivre, donnés à titre illustratif et non limitatif de l'invention.

### Brève description des dessins

[Fig 1] représente, de manière schématique, dans un plan vertical de coupe, des empilements multicouches conventionnels, de structure NIP 21 ou de structure PIN 22.
[Fig 2] représente, de manière schématique, dans un plan vertical de coupe, des empilements multicouches selon l'invention, de structure NIP 23 ou de structure PIN 24, intégrant une couche composite pérovskite/matériau de type P 17 dans le cas d'une structure NIP 23, et pérovskite/matériau de type N 18 dans le cas d'une structure PIN.
[Fig 3] représente, de manière schématique, dans un plan vertical de coupe, des cellules tandem silicium-pérovskite, comprenant un empilement multicouche conventionnel 25 (figure de gauche) ou comprenant un empilement 26 conforme à l'invention (figure de droite).
[Fig 4] représente, de manière schématique, le principe de l'analyse ToF-SIMS, effectuée en exemple 1, de la couche de poly[bis(4-phényl)(2,4,6-triméthylphényl)amine] (PTAA) et de la couche pérovskite d'un empilement conventionnel préparé en exemple 1 ;
[Fig 5] présente les courbes d'analyse ToF-SIMS pour les ions C₆H₆⁻ et Pb⁻, obtenues pour les couches de PTAA et pérovskite de l'empilement multicouche conventionnel de l'exemple 1 ;
[Fig 6] représente, de manière schématique, le principe de l'analyse ToF-SIMS, effectuée en exemple 1, de la couche couche composite pérovskite/PTAA d'un empilement selon l'invention préparée en exemple 1 ;
[Fig 7] présente les courbes d'analyse ToF-SIMS pour les ions C₆H₆⁻ et Pb⁻, obtenues pour la couche composite pérovskite/PTAA de l'empilement multicouche conforme à l'invention en exemple 1.

Il convient de noter que, pour des raisons de clarté, les différents éléments dans les figures sont représentés en échelle libre, les dimensions réelles des différentes parties n'étant pas respectées.

Dans la suite du texte, les expressions « compris entre ... et ... » et « allant de ... à ... » et « variant de ... à ... » sont équivalentes et entendent signifier que les bornes sont incluses, sauf mention contraire.

### Description détaillée

### EMPILEMENT MULTICOUCHE

Comme indiqué précédemment, l'invention concerne, selon un premier de ses aspects, un empilement multicouche, utile pour former un dispositif photovoltaïque, de structure NIP ou PIN, ledit empilement comportant au moins :
- une couche semi-conductrice inférieure de type N dans le cas d'une structure NIP, ou de type P dans le cas d'une structure PIN ; et
- une couche composite, superposée à ladite couche semi-conductrice inférieure, comprenant au moins un matériau pérovskite et au moins un matériau de type P dans le cas d'une structure NIP, ou de type N dans le cas d'une structure PIN, et présentant un gradient du ratio massique matériau P/matériau pérovskite dans le cas d'une structure NIP ou matériau N/matériau pérovskite dans le cas d'une structure PIN, dans le sens de l'interface entre ladite couche composite et ladite couche semi-conductrice inférieure vers la face opposée de ladite couche composite.

### Couche composite pérovskite/matériau de type P ou N

Une couche composite selon l'invention comprend, voire est formée d'au moins un matériau pérovskite et d'au moins un matériau de type P dans le cas d'un empilement de structure NIP, ou d'au moins un matériau de type N dans le cas d'un empilement de structure PIN. La couche composite selon l'invention est en contact direct avec la couche semi-conductrice sous-jacente de type N dans une structure NIP et de type P dans une structure PIN.

De manière avantageuse, la pérovskite est un matériau comportant 1, 2 ou 3 cations et des anions, par exemple des halogénures, notamment Cl⁻, Br⁻, I⁻ et leurs mélanges.

Le matériau pérovskite d'une couche composite selon l'invention peut être plus particulièrement un matériau de formule générale ABX₃, avec :
- A représentant un cation ou une combinaison de cations métalliques ou organiques ;
- B représentant un ou plusieurs éléments métalliques, tels que le plomb (Pb), l'étain (Sn), le bismuth (Bi) et l'antimoine (Sb) ; et
- X représentant un ou plusieurs anions, en particulier un ou plusieurs halogénures, et plus particulièrement choisis parmi le chlorure, le bromure, l'iodure et leurs mélanges.

De tels matériaux pérovskites sont notamment décrits dans le document WO 2015/080990. A titre d'exemple de matériaux pérovskites, on peut en particulier citer les pérovskites hybrides organiques-inorganiques. Ces matériaux pérovskites hybrides peuvent être plus particulièrement de formule ABX₃ précitée, dans laquelle A comprend un ou plusieurs cations organiques ou non.

Le cation organique peut être choisi parmi les cations organo-ammonium tels que :
- les cations alkyl-ammonium de formule générale R₁R₂R₃R₄N⁺, avec R₁, R₂, R₃ et R₄ étant indépendamment l'un de l'autre un atome d'hydrogène ou un radical alkyle en C₁-C₅, comme par exemple un cation de type méthyl-ammonium (MA) et
- les cations formamidinium (FA) de formule [R₁NCHNR₁]⁺, avec R₁ pouvant représenter un atome d'hydrogène ou un radical alkyle en C₁-C₅.

Le ou les cations organiques du matériau pérovskite hybride peuvent être éventuellement associés à un ou plusieurs cations métalliques, par exemple du césium.

A titre d'exemples de matériaux pérovskites hybrides, on peut plus particulièrement citer les pérovskites de formule ABX₃, avec :
- A représentant un cation organo-ammonium par exemple de type méthylammonium (MA⁺), un cation formamidinium (FA⁺) ou un mélange de ces deux cations, éventuellement associé à du césium (Cs⁺) ;
- B étant choisi parmi le plomb, l'étain, le bismuth, l'antimoine et leurs mélanges ; et
- X étant choisi parmi le chlorure, le bromure, l'iodure et leurs mélanges.

Le matériau pérovskite peut être en particulier CH₃NH₃PbI₃, dit encore PK avec le plomb pouvant être remplacé par l'étain ou le germanium et l'iode pouvant être remplacé par le chlore ou le brome.

Le matériau pérovskite peut également être un composé de formule CsₓFA₁₋ₓPb(I_{1-y}Br_{y})₃ avec x < 0,17 ; 0 < y < 1 et FA symbolisant le cation formamidinium.

Dans le cas d'un empilement de structure NIP, la couche composite selon l'invention comprend au moins un matériau de type P.

Un matériau « de type P » désigne un matériau permettant le transport des trous (h⁺).

Le matériau de type P peut être par exemple choisi parmi le Nafion, WO₃, MoOs, V₂O₅ et NiO, les polymères semi-conducteurs π-conjugués, éventuellement dopés, et leurs mélanges. De préférence, le matériau de type P est choisi parmi les polymères semi-conducteurs π-conjugués, éventuellement dopés.

A titre illustratif des polymères semi-conducteurs π-conjugués, éventuellement dopés, peuvent notamment être cités le poly(3-hexylthiophène) ou P3HT, le poly[N-9'-heptadécanyl-2,7-carbazole-alt-5,5-(4,7-di-2-thiényl-2',1',3'-benzothiadiazole ou PCDTBT, le poly[2,1,3-benzothiadiazole-4,7-diyl[4,4-bis(2-éthylhexyl)-4H-cyclopenta[2,1-b:3,4-b']dithiophène-2,6-diyl]] ou PCPDTBT, le poly(benzo[1,2-b:4,5-b']dithiophène-alt-thiéno[3,4-c]pyrrole-4,6-dione) ou PBDTTPD, poly[[4,8-bis[(2-éthylhexyl)oxy] benzo [1,2-b:4,5-b']dithiophène-2,6-diyl][3-fluoro-2-[(2-éthylhexyl) carbonyl]thiéno[3,4-b]thiophènediyl]] ou PTB7, le poly[bis(4-phényl)(2,4,6-triméthylphényl)amine] ou PTAA.

Les polymères semi-conducteurs π-conjugués peuvent être avantageusement dopés avec un ou plusieurs dopants de type P, tels qu'un sel de lithium, par exemple le bis(trifluorométhane)sulfonide de lithium (LiTFSI), et/ou la 4-tert-butylpyridine (t-BP). Convient également comme matériau de type P, un matériau conducteur de type PEDOT sous une forme combinée à un contre-anion, tel que le PEDOT :PSS.

Un matériau de type P préféré est un mélange de PEDOT et de PSS, ou encore le PTAA, de préférence dopé, en particulier avec un sel de lithium, tel que le bis(trifluorométhane)sulfonide de lithium (LiTFSI) et/ou la 4-tert-butylpyridine.

Le matériau de type P peut encore être choisi parmi les molécules semi-conductrices de type P telles que :
- la porphyrine ;
- les : 7,7'-(4,4-bis(2-ethylhexyl)-4H-silolo[3,2-b:4,5-b 2]dithiophene-2,6-diyl)bis(6-fluoro-4-(5'-hexyl-[2,2'-bithiophen]-5-yl)benzo[c][1,2,5]thiadiazole) : p-DTS(FBTTh2)2 ;
- les bore-dipyrométhènes (BODIPY) ; et
- les molécules à noyau(x) triphénylamine (TPA), comme par exemple le (E,E)-1,4-bis[2-[4-[N,N-bis(4-méthoxyphényl)amino]phényl]vinyl]benzène.

Ainsi, ledit matériau de type P peut être choisi parmi des polymères semi-conducteurs π-conjugués, éventuellement dopés, les polymères conducteurs de type PEDOT sous une forme combinée à un contre-anion, tel que le PEDOT :PSS et les molécules semi-conductrices de type P, en particulier celles à noyau(x) triphénylamine ; en particulier ledit matériau de type P peut être choisi parmi un mélange de PEDOT et de PSS, le poly[bis(4-phényl)(2,4,6-triméthylphényl)amine] (PTAA), éventuellement dopé avec un sel de lithium et/ou la 4-tert-butylpyridine et le (E,E)-1,4-bis[2-[4-[N,N-bis(4-méthoxyphényl)amino]phényl]vinyl]benzène.

Dans le cas d'un empilement de structure PIN, la couche composite selon l'invention comprend au moins un matériau de type N.

Un matériau « de type N » désigne un matériau qui permet le transport des électrons (e⁻). Il peut être plus particulièrement choisi parmi les oxydes métalliques. Les oxydes métalliques peuvent se présenter par exemple sous la forme de nanoparticules d'oxydes métalliques. Les oxydes métalliques de type N peuvent être notamment choisis parmi l'oxyde de zinc ZnO, les oxydes de titane TiOₓ avec x compris entre 1 et 2, l'oxyde d'étain (SnO₂), les oxydes de zinc dopés, par exemple l'oxyde de zinc dopé à l'aluminium (AZO), l'oxyde de zinc dopé à l'indium (IZO), l'oxyde de zinc dopé au gallium (GZO), les oxydes de titane dopés, par exemple l'oxyde de titane dopé à l'azote, au phosphore, au fer, au tungstène ou au manganèse, les oxydes d'étain dopés par exemple au fluor, et leurs mélanges.

En particulier, le matériau de type N de la couche composite selon l'invention peut être choisi parmi l'oxyde d'étain (SnO₂), les oxydes de zinc dopés, en particulier l'oxyde de zinc dopé à l'aluminium (AZO) et leurs mélanges.

Selon une variante de réalisation, l'empilement multicouche selon l'invention est de type NIP, et ladite couche composite comprend, voire est formée, d'au moins un matériau pérovskite et d'au moins un matériau de type P, en particulier tels que définis précédemment. Selon un mode de réalisation particulier, une couche composite selon l'invention comprend, voire est formée :
- d'un matériau pérovskite de formule ABX₃ telle que définie précédemment, en particulier de formule CsₓFA₁₋ₓPb(I_{1-y}Br_{y})₃ avec x < 0,17 ; 0 < y < 1 et FA symbolisant le cation formamidinium ; et
- d'un matériau de type P, tel que défini précédemment, en particulier choisi parmi les polymères semi-conducteurs π-conjugués, éventuellement dopés, et notamment le PTAA, éventuellement dopé avec un sel de lithium et/ou la 4-tert-butylpyridine.

Une couche composite selon l'invention présente de préférence une épaisseur inférieure ou égale à 1 µm, en particulier comprise entre 200 et 800 nm et plus particulièrement comprise entre 300 et 600 nm.

Comme évoqué précédemment, une couche composite selon l'invention présente une répartition inhomogène des matériaux pérovskite et de type P (ou de type N).

Plus précisément, la couche composite présente un gradient du ratio massique matériau P (ou N)/matériau pérovskite, dans le sens de l'interface entre ladite couche composite et la couche semi-conductrice sous-jacente, vers la face opposée de ladite couche composite. Par « gradient du ratio massique matériau P (ou N)/matériau pérovskite », on entend un ratio massique matériau P (ou N)/matériau pérovskite croissant dans le sens indiqué par le gradient, autrement dit croissant selon l'invention depuis l'interface entre ladite couche composite et la couche semi-conductrice sous-jacente jusqu'à la face opposée de ladite couche composite.

Autrement dit, le ratio massique matériau matériau P (ou N)/pérovskite est moins élevé au voisinage de l'interface entre ladite couche composite et la couche semi-conductrice sous-jacente qu'au voisinage de la face opposée.

En particulier, la distribution des matériaux pérovskite et de type P (ou de type N) est telle qu'au voisinage de l'interface entre ladite couche composite et la couche semi-conductrice sous-jacente, la couche composite selon l'invention est formée majoritairement, voire exclusivement, du matériau pérovskite ; tandis qu'au voisinage de la face de ladite couche composite, opposée à l'interface entre la couche composite et la couche semi-conductrice sous-jacente, autrement dit, au voisinage de l'interface entre la couche composite et l'électrode supérieure, la couche composite selon l'invention est formée majoritairement du matériau de type P dans le cas d'une structure NIP ou de type N dans le cas d'une structure PIN, autrement dit est localement de type P ou de type N.

Une couche composite selon l'invention comprend une zone dans laquelle le matériau pérovskite et le matériau de type P (ou de type N) forment une structure interpénétrée. En particulier, la couche composite selon l'invention comprend une zone dans laquelle lesdits matériaux pérovskite et de type P (ou de type N) sont mélangés à l'échelle submicronique.

Cette zone interpénétrée s'étend sur une épaisseur d'au moins 10 nm, en particulier sur une épaisseur comprise entre 10 et 150 nm, de la couche composite selon l'invention.

En particulier, cette zone interpénétrée est composée du ou desdits matériaux de type P (ou de type N) incorporé dans une matrice pérovskite. Autrement dit, les domaines de pérovskite sont recouverts par le matériau de type P (ou de type N). Cette structure peut être identifiée par analyse de ladite couche composite par microscopie électronique à balayage (MEB), associée à la microanalyse par énergie dispersive de rayons X (EDX).

Les domaines de pérovskite cristallisée peuvent présenter une taille moyenne supérieure à 100 nm, en particulier supérieure à 200 nm et de manière préférentielle, supérieure à 300 nm. Par taille, on entend la dimension la plus importante des domaines de pérovskite, par exemple le diamètre pour des grains de forme globalement sphérique.

La taille moyenne des domaines de pérovskite cristallisée peut être mesurée au microscope électronique à balayage.

Ainsi, une couche composite selon l'invention peut plus particulièrement présenter, dans le sens de l'interface entre ladite couche composite et la couche semi-conductrice sous-jacente vers la face de ladite couche composite, opposée à l'interface entre la couche composite et la couche semi-conductrice sous-jacente, autrement dit, vers l'interface entre la couche composite et l'électrode supérieure :
- une première zone formée majoritairement du matériau de type pérovskite, voire exclusivement constituée du matériau de type pérovskite ;
- une zone comprenant un mélange des matériaux pérovskite et de type P dans le cas d'une structure NIP ou de type N dans le cas d'une structure PIN ; et
- une zone formée majoritairement, voire exclusivement constituée, du matériau de type P dans le cas d'une structure NIP ou de type N dans le cas d'une structure PIN.

Comme évoqué précédemment, l'empilement selon l'invention présente une structure dite « planaire ». En particulier, une couche composite selon l'invention est une couche compacte, non mésoporeuse. Elle diffère ainsi de structures dites mésoporeuses, dans lesquelles un matériau est incorporé dans les pores d'un autre matériau.

### Autres couches de l'empilement multicouche

La couche semi-conductrice inférieure, sous-jacente à la couche composite selon l'invention, de type N dans une structure NIP, ou de type P dans une structure PIN, peut être formée d'un ou plusieurs matériaux de type N, respectivement de type P, tels que décrits précédemment pour la composition de la couche composite, et éventuellement dopés.

Elle peut présenter typiquement une épaisseur totale comprise entre 100 nm et 2 µm, en particulier entre 400 et 800 nm.

Selon un mode de réalisation particulier, la couche semi-conductrice inférieure de type N ou de type P présente une épaisseur comprise entre 10 nm et 200 nm, en particulier entre 20 nm et 100 nm.

Comme indiqué précédemment, un empilement multicouche selon l'invention peut être destiné à un dispositif photovoltaïque, notamment une cellule photovoltaïque pérovskite, en structure de type NIP ou PIN, ou encore de type tandem.

De préférence, l'empilement multicouche selon l'invention est en structure dite NIP. Un tel empilement peut comprendre les couches suivantes, jointives les unes aux autres et dans cet ordre de superposition :
- une couche semi-conductrice de type N, et
- une couche composite pérovskite/matériau P, telle que définie précédemment. Alternativement, dans le cas d'une structure PIN, un empilement multicouche selon l'invention peut comprendre les couches suivantes, jointives les unes aux autres et dans cet ordre de superposition :
- une couche semi-conductrice de type P, et
- une couche composite pérovskite/matériau N, telle que définie précédemment.

Comme représenté en figure 2, un dispositif photovoltaïque, en particulier une cellule photovoltaïque pérovskite en structure NIP 23 ou PIN 24 peut plus particulièrement comporter, dans cet ordre de superposition, au moins :
- un substrat 11, en particulier transparent, rigide ou souple , tel qu'un substrat en verre ou en matière plastique, notamment en poly(téréphtalate d'éthylène) (PET) ;
- une première électrode, dite électrode inférieure 12 ;
- une couche semi-conductrice inférieure, de type N 13 dans le cas d'une structure NIP ou de type P 15 dans le cas d'une structure PIN, en particulier telle que définie précédemment ;
- une couche composite, telle que définie ci-dessus, de type pérovskite/matériau P 17 dans le cas d'une structure NIP ou de type pérovskite/matériau N 18 dans le cas d'une structure PIN ; et
- une deuxième électrode, dite électrode supérieure 16.

De préférence, un empilement multicouche selon l'invention est destiné à un dispositif photovoltaïque, en particulier une cellule photovoltaïque, de type pérovskite en structure NIP.

Le substrat 11 mis en oeuvre dans un dispositif photovoltaïque, en particulier une cellule photovoltaïque, comprenant un empilement multicouche selon l'invention, fait référence à une structure de base solide, sur une des faces de laquelle est formée l'électrode inférieure. Il peut se présenter sous la forme d'une plaque. Il peut être rigide ou souple (flexible) .

Il peut être de diverses natures, par exemple en verre ou en matière plastique, en particulier en polyester, de préférence en polyéthylène téréphtalate (PET), polyéthylène naphtalate (PEN) ou en polycarbonates.

Il peut notamment s'agir d'une plaque en verre.

L'électrode inférieure 12, au contact du support, peut être formée d'une couche transparente conductrice, par exemple en oxyde(s) conducteur(s) transparent(s) (TCO) tels que l'oxyde d'indium dopé à l'étain (ITO), l'oxyde de zinc dopé à l'aluminium (AZO), l'oxyde de zinc dopé au gallium (GZO), l'oxyde de zinc dopé à l'indium (IZO) et leurs mélanges, ou encore être formée d'un ensemble multicouche, par exemple AZO/Ag/AZO.

Elle peut également être formée par un réseau de nanofils, notamment en argent.

L'électrode supérieure 16 peut être par exemple formée par une couche en or, en argent, ou par un réseau de nanofils, de préférence en argent. Elle peut également être en aluminium ou en oxyde conducteur transparent.

Selon encore une autre variante de réalisation, un empilement multicouche selon l'invention peut être destiné à une cellule photovoltaïque de type multijonction, en particulier de type « tandem » ou à double jonction, dont l'un au moins des matériaux actifs est un matériau pérovskite.

De telles cellules de type tandem comportent typiquement deux ensembles multicouches empilés l'un sur l'autre, et dont les couches actives respectives présentent généralement des spectres d'absorption de la lumière différents. Dans ces cellules de type tandem, les photons non absorbés par la première couche active peuvent l'être par la seconde. La quantité de photons récupérés par l'ensemble des couches actives de la cellule est ainsi augmentée et le rendement électrique de cette dernière, amélioré.

Un dispositif photovoltaïque de type tandem selon l'invention peut comporter un empilement selon l'invention, en structure NIP ou PIN, de préférence en structure NIP, tel que décrit précédemment.

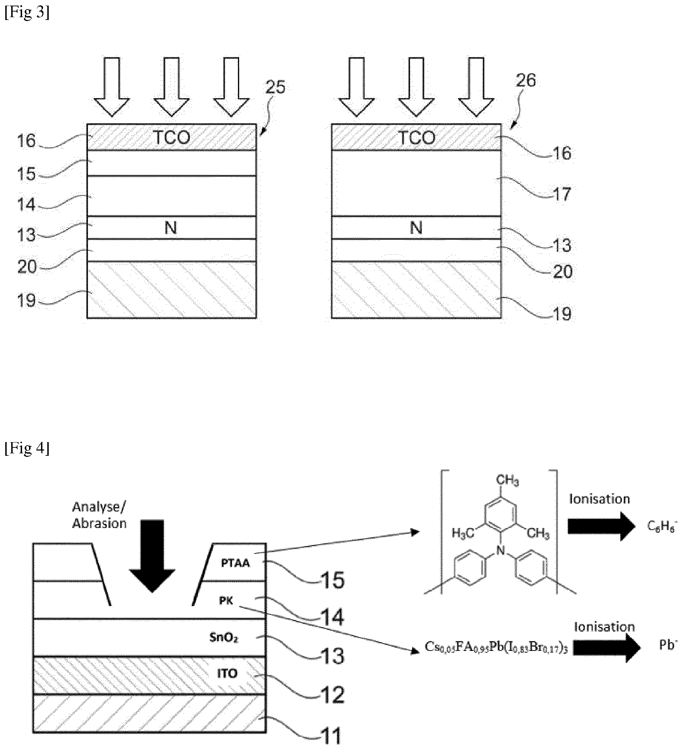

Il peut s'agir par exemple d'une cellule tandem silicium-pérovskite 26 telle que représentée schématiquement en figure 3.

Un dispositif photovoltaïque de type tandem selon l'invention peut plus particulièrement comporter une première sous-cellule, par exemple à base de silicium cristallin, sur laquelle est empilée une sous-cellule à base de pérovskite comprenant un empilement multicouche selon l'invention, et plus particulièrement, comprenant, dans cet ordre de superposition, comme représentée en figure 3, au moins :
- une couche semi-conductrice inférieure de type N 13 dans le cas d'une structure NIP ou de type P dans le cas d'une structure PIN ;
- une couche composite selon l'invention, de typé pérovskite/matériau P 17 dans le cas d'une structure NIP ou de type pérovskite/matériau N dans le cas d'une structure PIN, et
- une électrode supérieure transparente, en particulier en oxyde conducteur transparent (TCO).

Dans le cas de l'élaboration de cellules photovoltaïques de type tandem, la mise en oeuvre d'une couche composite selon l'invention s'avère particulièrement avantageuse du point de vue optique. En effet, dans une telle structure, l'éclairement se fait *via* la face supérieure, comme représenté schématiquement en figure 3, et doit donc traverser la couche semi-conductrice d'interface (de type P 15 dans une structure NIP comme représenté en figure 3 ; de type N dans une structure PIN), avant d'atteindre la couche active pérovskite.

En revanche, dans une structure mettant en oeuvre une couche composite selon l'invention, par exemple une couche composite pérovskite/couche P 17 comme représenté en figure 3, l'effet filtre dû à la couche d'interface supérieure est avantageusement réduit. Également, les possibles pertes par réflexions à l'interface pérovskite/couche d'interface sont avantageusement réduites.

Le dispositif photovoltaïque peut comporter en outre des moyens de connexion électrique, notamment des reprises de contact, qui permettent de relier les électrodes pour alimenter en courant un circuit électrique.

### PROCEDE DE PREPARATION D'UN EMPILEMENT SELON L'INVENTION

L'invention concerne encore un procédé de préparation d'un empilement selon l'invention dans lequel une couche composite telle que définie précédemment est formée par dépôt successif des matériaux pérovskite et de type P (ou de type N), de préférence par voie humide, avant cristallisation de la pérovskite.

Le procédé de l'invention met en oeuvre au moins les étapes consécutives suivantes :
(a) disposer d'une structure présentant, en surface, une couche semi-conductrice de type N, dans le cas de la formation d'un empilement de structure NIP, ou de type P dans le cas de la formation d'un empilement de structure PIN,
(b) former, en surface de ladite couche semi-conductrice de type N ou de type P, un film humide à partir d'une solution de précurseurs du matériau pérovskite dans un ou plusieurs solvants ;
(c) ajouter audit film humide de l'étape (b) au moins un matériau de type P dans le cas de la formation d'un empilement NIP, et de type N dans le cas d'un empilement PIN ; et
(d) soumettre l'ensemble à un traitement thermique propice à l'élimination des solvants et à la cristallisation du matériau pérovskite.

La couche composite selon l'invention est formée par voie humide, c'est-à-dire par une technique mettant en oeuvre le dépôt de solutions ou dispersions liquides. Selon un mode de réalisation particulier, la formation d'un empilement multicouche intégrant une couche composite selon l'invention peut ainsi être plus particulièrement opérée *via* au moins les étapes suivantes :
(a) disposer d'une structure présentant, en surface, une couche semi-conductrice de type N dans le cas de la préparation d'un empilement de structure NIP, ou de type P dans le cas de la préparation d'un empilement de structure PIN ;
(b) déposer, en surface de ladite couche semi-conductrice de type N ou de type P, une solution de précurseurs du matériau pérovskite dans un ou plusieurs solvants ;
(c) déposer, en surface du film humide formé en étape (b), une formulation d'au moins un matériau de type P dans le cas d'un empilement NIP, ou de type N dans le cas d'un empilement PIN, dans un ou plusieurs solvants, dits « anti-solvants, dans lesquels les précurseurs du matériau pérovskite ne sont pas solubles ; et
(d) soumettre l'ensemble à un traitement thermique propice à l'élimination des solvants et à la cristallisation du matériau pérovskite.

Il est entendu que la structure de départ, présentant en surface une couche semi-conductrice de type N (ou de type P), mise en oeuvre en étape (a) du procédé de l'invention, est adaptée au dispositif photovoltaïque auquel l'empilement multicouche selon l'invention est destiné. Elle peut plus particulièrement comprendre, dans le cadre de la préparation d'une cellule photovoltaïque pérovskite en structure NIP ou PIN, comme représenté schématiquement en figure 2, dans cet ordre de superposition :
- un substrat 11 tel que défini précédemment ;
- une première électrode 12, dite électrode inférieure, en particulier telle que définie précédemment ;
- ladite couche semi-conductrice de type N 13 (ou de type P 15).

Dans le cas de l'élaboration d'une cellule photovoltaïque de type tandem, par exemple de type silicium-pérovskite, comme représenté schématiquement en figure 3, la structure présentant en surface une couche semi-conductrice de type N (ou de type P) peut comprendre l'empilement suivant :
- une première sous-cellule, par exemple à base de silicium 19,
- une couche dite de recombinaison, par exemple formée d'un oxyde transparent conducteur, notamment choisi parmi les oxydes conducteurs transparents indiqués précédemment pour l'électrode inférieure ; et
- ladite couche semi-conductrice de type N 13 (ou de type P).

On désigne, de manière courante, sous l'appellation « encre », une solution, dispersion ou suspension de matériau(x) mise en oeuvre pour l'élaboration de couches pour un empilement multicouche utile pour former un dispositif photovoltaïque.

Les encres comprennent généralement un ou plusieurs solvants, un ou plusieurs matériaux constituant la couche, et éventuellement un ou plusieurs additifs, par exemple un plastifiant et/ou un liant et/ou un dispersant.

La solution de précurseurs du matériau pérovskite, désignée plus simplement dans la suite du texte sous l'appellation « encre pérovskite », peut comprendre typiquement les précurseurs du matériau pérovskite dans un ou plusieurs solvants. L'homme du métier est à même de choisir la nature et les proportions en précurseurs de pérovskite à mettre en oeuvre pour obtenir le matériau pérovskite souhaité.

Le ou lesdits solvants sont choisis au regard de la nature du ou des précurseurs de pérovskite, de manière à permettre leur solubilisation. Les solvants sont classiquement choisis parmi des solvants organiques polaires, en particulier choisis parmi le diméthylformamide (DMF), le diméthylsulfoxyde (DMSO), la gamma-butyrolactone (GBL), et leurs mélanges.

De préférence, le ou lesdits solvants de l'encre pérovskite sont choisis parmi le DMF, le DMSO et leurs mélanges.

La formulation à base de matériau de type P (ou de type N), désignée dans la suite du texte sous l'appellation « encre de type P » (respectivement « encre de type N ») comprend typiquement le ou lesdits matériaux de type P (respectivement de type N) dans un ou plusieurs « anti-solvants ».

Le ou lesdits solvants, dits « anti-solvants » sont des solvants dits « orthogonaux » vis-à-vis des précurseurs du matériau pérovskite. Par solvant « orthogonal » vis-à-vis des précurseurs du matériau pérovskite, on entend un solvant non susceptible de dissoudre lesdits précurseurs du matériau pérovskite. Il est entendu que la nature du ou desdits anti-solvants est choisie au regard de la nature des précurseurs de matériau pérovskite.

Comme évoqué précédemment, les anti-solvants sont classiquement utilisés lors de la réalisation d'une couche cristallisée de pérovskite, pour opérer la phase dite de « quenching », subséquente au dépôt de la solution de précurseurs de pérovskite. De tels anti-solvants sont par exemple décrits dans la publication Paek *et al.* [3]*.*

Les anti-solvants sont typiquement choisis parmi le diéthyléther ; le dichlorométhane ; des composés aromatiques à un, deux ou trois cycles, substitués, en particulier substitués par un ou plusieurs groupements alkyles, notamment méthyle, et/ou halogène, en particulier chlore, tels que le toluène, le chlorobenzène, le xylène, le méthylnaphtalène ; et leurs mélanges.

De préférence, l'anti-solvant est le chlorobenzène.

La concentration en matériau(x) de type P (ou de type N) dans l'encre de type P (ou de type N) mise en oeuvre peut être comprise entre 2 g/L et 30 g/L, de préférence entre 4 g/L et 20 g/L.

Les concentrations en précurseurs de pérovskite et en matériau(x) de type P ou de type N dans les encres déposées sont ajustées au regard notamment de l'épaisseur finale de la couche composite souhaitée.

Le dépôt des encres au cours du procédé de préparation d'une couche composite selon l'invention peut être réalisé au moyen d'une technique de dépôt par voie solvant choisie parmi le dépôt à la tournette ou enduction centrifuge (plus connue sous l'appellation « spin-coating » en terminologie anglo-saxonne), le dépôt au racloir, le couchage à lame (« blade-coating » en terminologie anglo-saxonne), le dépôt par spray ultrasonique, l'enduction par filière à fente (« slot-die » an terminologie anglo-saxonne), l'enduction par trempage (« dip-coating » en terminologie anglo-saxonne), l'impression jet d'encre, l'héliogravure, la flexographie et la sérigraphie.

Selon une variante de réalisation, l'encre pérovskite et/ou l'encre de type P (ou de type N) est(sont) déposée(s) par spin-coating.

De préférence, l'encre pérovskite et l'encre de type P (ou de type N) sont déposées par une même technique de dépôt, avantageusement par spin-coating.

Il appartient aux compétences de l'homme du métier d'ajuster les conditions du dépôt de ladite encre de type P (ou de type N), sur le film humide de solution de précurseurs de pérovskite, pour obtenir, après recuit thermique, ladite couche composite souhaitée, telle que décrite précédemment.

Par « film humide », on entend signifier que le film sur lequel est déposée l'encre de type P (ou de type N) comprend un ou plusieurs solvants. Autrement dit, le dépôt de l'encre de type P (ou de type N) est opéré avant l'élimination totale du ou desdits solvants du film d'encre pérovskite préalablement déposé.

Selon un mode de réalisation particulier, les étapes (b) et (c) du procédé de l'invention peuvent être opérées consécutivement, par spin-coating, l'étape (c) étant réalisée sans stopper la rotation du plateau tournant du dispositif de spin-coating.

Plus particulièrement, selon cette variante de réalisation, la structure présentant en surface une couche semi-conductrice de type N (ou de type P) est fixée sur le porte échantillon du dispositif de spin-coating. La solution de précurseurs de pérovskite est ensuite déposée en surface de ladite couche de type N (ou de type P), puis le substrat est mis en rotation rapide par la tournette, pour former un film mince et régulier de l'encre pérovskite. La formulation de matériau(x) de type P (ou de type N) dans un ou plusieurs anti-solvant(s) est alors déposée, en particulier à vitesse contrôlée (ou égouttée) en surface du film humide de l'encre pérovskite, sans stopper la rotation.

Le dépôt par spin-coating en étape (b) et (c) peut être opéré par exemple avec une vitesse de rotation comprise entre 500 et 8000 rpm. L'encre de type P (ou de type N) peut être par exemple déposée à la surface du film humide de solution de précurseurs de pérovskite entre 5 à 35 secondes, en particulier entre 5 et 20 secondes avant la fin du programme de dépôt de la solution de précurseurs de pérovskite.

Il appartient à l'homme du métier d'ajuster les paramètres du dépôt, notamment en termes de durée écoulée entre le dépôt de la solution de précurseurs de pérovskite par spin-coating et le dépôt de l'encre de type P ou de type N, pour accéder, après recuit, à une couche composite selon l'invention. En particulier, l'encre de type P ou de type N est déposée après formation, à la surface de la couche semi-conductrice inférieure, d'un film humide de solution de précurseurs de pérovskite (encre pérovskite), d'épaisseur homogène, et avant évaporation du ou des solvants de l'encre pérovskite déposée.

L'élimination totale des solvants peut être réalisée de manière conventionnelle, par exemple par séchage thermique.

L'ensemble est ensuite chauffé pour cristalliser le matériau pérovskite. Il appartient à l'homme du métier d'ajuster les conditions de recuit thermique pour obtenir le matériau pérovskite souhaité. Le recuit thermique peut être notamment opéré à une température comprise entre 60 et 150 °C, en particulier entre 80 et 120 °C. La durée du recuit peut être comprise entre 5 et 120 minutes, en particulier entre 15 et 90 minutes et plus particulièrement entre 30 et 60 minutes.

L'invention va maintenant être décrite au moyen des exemples suivants, donnés bien entendu à titre illustratif et non limitatif de l'invention.

### Exemple

### Exemple 1

Formulation d'une couche composite pérovskite + matériau P (PTAA dopé avec Li-TFSI)

Le matériau de type P est le poly[bis(4-phényl)(2,4,6-triméthylphényl)amine] (PTAA) dopé avec un sel de lithium (Li-TFSI).

A partir d'une poudre commerciale de PTAA (Mw d'environ 14500 g/mol), est préparée une formulation de PTAA à une concentration de 12 g/L dans du toluène anhydre.

Cette formulation de PTAA est complétée par l'ajout, pour 1,5 mL de la solution de PTAA dans le toluène, de 15,75 µL d'une solution de Li-TFSI à 170 g/L dans l'acétonitrile et de 8,4 µL de 4-tert-butylpyridine (t-BP).

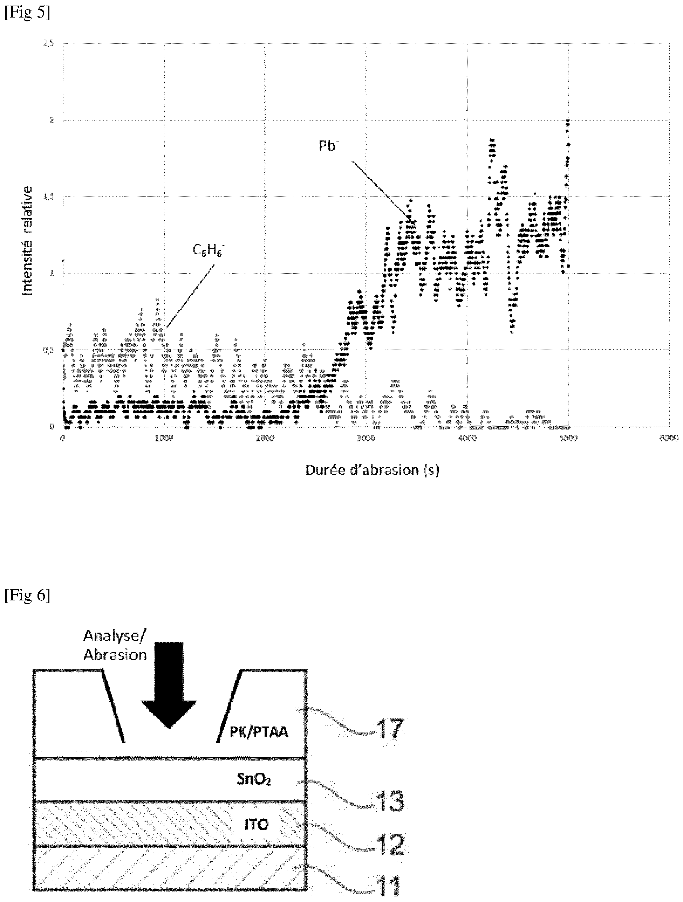

Un empilement multicouche conforme à l'invention, tel que représenté schématiquement en figure 6, intégrant une couche composite 17 pérovskite/PTAA est préparée suivant le protocole suivant.

Un substrat de verre 11 d'épaisseur de 1,1 mm, recouvert d'une couche d'ITO 12 formant l'électrode inférieure, est recouvert d'une couche N d'oxyde d'étain (SnO₂) 13. La couche N est formée par enduction centrifuge (« spin-coating »).

Une encre pérovskite, formée des précurseurs PbI₂, PbBr₂, CsI et FAI dans un mélange de DMF et de DMSO, est déposée à la surface de la couche de SnO₂ par spin-coating. Sans stopper la rotation de la structure, la solution de PTAA, préparée ci-dessus (250-350 µL) est déposée à la surface de la structure.

La solution de PTAA sert ainsi de formulation de « quenching » de la pérovskite. Le film ainsi « quenché » est ensuite recuit pendant une heure à 100 °C pour former la couche composite pérovskite Cs_{0,05}FA_{0,95}Pb(I_{0,83}Br_{0,17})₃/PTAA.

La couche composite pérovskite + PTAA présente une épaisseur d'environ 400 nm.

A titre de comparaison, un empilement multicouche conventionnel, tel que représenté schématiquement en figure 4, est préparé, dans des conditions similaires, par :
- dépôt d'une couche d'ITO 12 en surface d'un substrat de verre 11 ;
- dépôt par spin-coating d'une couche N d'oxyde d'étain 13 ;
- dépôt d'une solution des précurseurs de pérovskite PbI₂, PbBr₂, CsI et FAI dans un mélange de DMF et de DMSO, à la surface de la couche de SnO₂ par spin-coating, suivi d'un « quenching » par du toluène et recuit pendant une heure à 100 °C pour former la couche couche pérovskite Cs_{0,05}FA_{0,95}Pb(I_{0,83}Br_{0,17})₃ d'une épaisseur d'environ 350 nm ; et
- formation en surface de la couche de pérovskite, d'une couche de type P, par dépôt par spin-coating de la formulation de PTAA.

Les couches de PTAA et pérovskite de l'empilement conventionnel d'une part, et la couche composite PTAA/pérovskite de l'empilement selon l'invention sont analysées par analyse par spectrométrie de masse d'ions secondaires à temps de vol (ToF-SIMS) en profondeur. Les profils en profondeur sont obtenus en alternant des séquences d'analyse et d'abrasion, comme représenté en figures 4 et 6.

L'analyse des ions secondaires émis C₆H₆⁻ et Pb⁻ est représentative, respectivement, de la présence du PTAA et de la pérovskite.

Les courbes d'analyse ToF-SIMS pour les ions C₆H₆⁻ et Pb⁻ des couches PTAA et pérovskite de l'empilement conventionnel, préparé comme décrit précédemment, sont représentées schématiquement en figure 5. L'analyse ToF-SIMS permet d'identifier clairement une couche supérieure de PTAA (ions C₆H₆⁻ détectés), suivie d'une couche de pérovskite (ions Pb⁻ détectés).

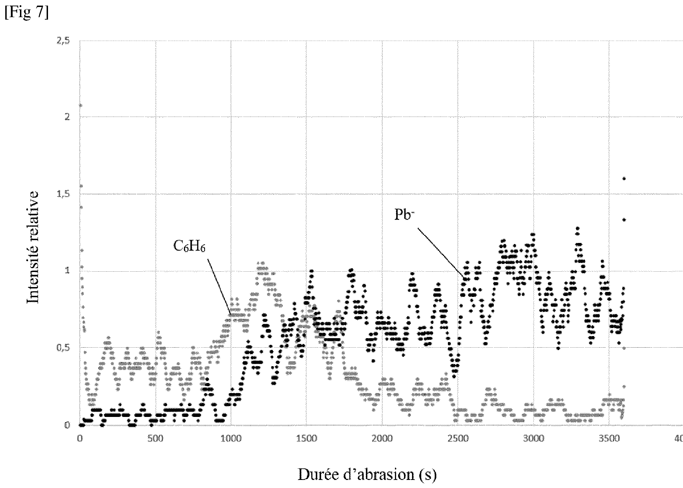

Les courbes d'analyse ToF-SIMS pour les ions C₆H₆⁻ et Pb⁻ de la couche composite pérovskite/PTAA de l'empilement selon l'invention, préparé comme décrit précédemment, sont représentées schématiquement en figure 7.

L'analyse ToF-SIMS permet d'identifier une concentration croissante du matériau pérovskite (ions Pb⁻ détectés) et une concentration décroissante du matériau de type P (ions C₆H₆⁻), depuis la surface libre de la couche composite formée jusqu'à l'interface entre la couche composite et la couche N sous-jacente. En particulier, trois zones peuvent être distinguées, depuis l'interface entre la couche composite formée et la couche N sous-jacente jusqu'à la surface libre de la couche composite : une première zone formée majoritairement du matériau pérovskite, une zone comprenant un mélange du matériau pérovskite et du matériau de type P et une zone formée majoritairement du matériau de type P.

### Evaluation des performances du dispositif

Une électrode supérieure (couche d'or, d'épaisseur 100 nm) est ensuite évaporée à la surface de la couche composite pérovskite+PTAA.

L'ensemble du dispositif est réalisé en boîte à gants sous atmosphère interne. La surface active du dispositif de type NIP ainsi formé, de structure Verre/ITO/couche N/composite pérovskite+PTAA/Au, est de 0,33 cm².

Les performances photovoltaïques du dispositif ont été mesurées à 25 °C dans des conditions standards d'éclairement (1000 W.m⁻², AM 1,5 G).

Les paramètres caractéristiques du fonctionnement du dispositif (tension de circuit ouvert Voc, densité de courant de court-circuit Jsc, facteur de forme FF et rendement de conversion PCE) sont déterminés à partir de ces courbes.

Les résultats obtenus sont présentés dans le tableau 1 suivant.

**[Tableau 1]**

| Dispositif | Voc (mV) | Jsc (mA/cm²) | FF (%) | PCE (%) |
|---|---|---|---|---|
| Conforme à l'invention (avec une couche composite pérovskite+PTAA) | 1048 | 19,7 | 69,7 | 14,4 |

### Exemple 2

### Formulation d'une couche composite pérovskite + matériau P de différentes natures

### 2.1. Couches composites avec des matériaux P alternatifs

Des empilements multicouches conformes à l'invention, incorporant une couche composite pérovksite/matériau P, sont préparés suivant un protocole similaire à celui décrit en exemple 1, en changeant la formulation du PTAA par les formulations suivantes :
- formulation d'une encre de PTAA non dopé :
   Une formulation de PTAA non dopé, à une concentration de 9g/L dans du toluène anhydre est préparée à partir d'une poudre commerciale de polymère PTAA (Mw d'environ 14 500 g/mol).
- formulation d'une encre de petite molécule de type P, notée HTM (également non dopé) A partir d'une poudre de petite molécule commerciale (E,E)-1,4-bis[2-[4-[N,N-bis(4-méthoxyphényl)amino]phényl]vinyl]benzène (notée HTM), une solution de HTM à 30 g/L dans du chlorobenzène anhydre a été préparée.

Les couches d'ITO et d'oxyde d'étain sont préparés comme décrit précédemment en exemple 1.

Un substrat de verre 11 d'épaisseur de 1,1 mm, recouvert d'une couche d'ITO 12 formant l'électrode inférieure, est recouvert d'une couche N d'oxyde d'étain (SnO₂) 13. La couche N est formée par enduction centrifuge (« spin-coating »).

Les couches composites sont préparées comme décrit en exemple 1.

Le substrat verre/ITO/SnO₂ est recouvert d'encre pérovskite (solution des précurseurs de pérovskite telle que mise en oeuvre en exemple 1), puis l'ensemble est mis en rotation (procédé spin-coating). Un volume donné de solution de PTAA (respectivement de HTM) d'environ 400 µL, est ensuite déposé sur le substrat avant la fin de la rotation. Le film ainsi « quenché » est ensuite recuit pendant une heure à 100 °C pour former la couche composite pérovskite Cs_{0,05}FA_{0,95}Pb(I_{0,83}Br_{0,17})₃/PTAA (ou HTM).

Des dispositifs de référence sont également réalisés avec les bi-couches à titre de comparaison.

### Evaluation des performances des dispositifs

Une électrode supérieure (couche d'or, d'épaisseur 100 nm) est ensuite évaporée à la surface des empilements obtenus, et les performances photovoltaïques des dispositifs obtenus sont testées dans les conditions décrites en exemple 1.

Les résultats obtenus sont présentés dans le tableau 2 suivant.

**[Tableau 2]**

| Dispositif | Voc (mV) | Jsc (mA/cm²) | FF (%) | PCE (%) |
|---|---|---|---|---|
| Référence bi-couche pérovskite et PTAA non dopé | 1 071 | 22,10 | 47,2 | 11,2 |
| Avec couche composite PK/PTAA non dopé | 1 098 | 23,13 | 66,8 | 17,0 |
| Référence bi-couche pérovskite et HTM | 1 070 | 20,76 | 57,8 | 12,8 |
| Avec couche composite PK/HTM | 933 | 20,53 | 60,2 | 12,0 |

### 2.2. Couche composite avec une pérovskite alternative

Le même protocole que celui décrit précédemment est mis en oeuvre pour former une couche composite intégrant une pérovskite dont la stoechiométrie est différente (Cs_{0,05}FA_{0.95}Pb(I_{0.91}Br_{0.09})₃ et le PTAA non dopé.

Cette pérovskite est donc plus riche en iode, et son bandgap est donc légèrement réduit par rapport à celle décrite dans les exemples précédents. L'architecture des dispositifs et les conditions de mise en oeuvre des autres couches sont identiques à ceux des exemples décrits au point 2.1.

Les performances du dispositif ainsi obtenu sont données dans le Tableau 3.

**[Tableau 3]**

| Voc (mV) | Jsc (mA/cm²) | FF (%) | PCE (%) |
|---|---|---|---|
| 1055 | 23,7 | 70,5 | 17,6 |

### Liste des documents cités

[1] Rong et al "Challenges for commercializing perovskite solar cells," Science 361, 2018-09-21;
[2] Xiao et al "A Fast Deposition-Crystallization Procedure for Highly Efficient Lead Iodide Perovskite Thin-Film Solar Cells", Angew. Chem., 126, 2014-09-08, 10056-10061;
[3] Paek et al "From Nano- to Micrometer Scale: The Rôle of Antisolvent Treatment on High Performance Perovskite Solar Cells", Chem. Mater. 29, 2017-03-26, 3490-3498.

## Revendications

1. Empilement multicouche, utile pour former un dispositif photovoltaïque, de structure NIP ou PIN, ledit empilement présentant une architecture planaire et comprenant au moins :
- une couche semi-conductrice, dite couche semi-conductrice inférieure, de type N (13) dans le cas d'une structure NIP, ou de type P (15) dans le cas d'une structure PIN ; et
- une couche composite, superposée à ladite couche conductrice inférieure, comprenant au moins un matériau pérovskite et au moins un matériau de type P dans le cas d'une structure NIP (17) ou de type N dans le cas d'une structure PIN (18), et présentant un gradient du ratio massique matériau P/matériau pérovskite dans le cas d'une structure NIP ou matériau N/matériau pérovskite dans le cas d'une structure PIN, dans le sens de l'interface entre ladite couche composite et ladite couche semi-conductrice inférieure vers la face opposée de ladite couche composite ;
ledit matériau pérovskite et ledit matériau de type P ou de type N formant au sein de ladite couche composite, sur une épaisseur d'au moins 10 nm, une structure interpénétrée, ladite structure interpénétrée étant formée d'une matrice à base dudit matériau de type P ou de type N, dans laquelle sont incorporés des domaines de pérovskite cristallisée et
ladite couche composite étant formée par dépôt successif desdits matériaux pérovskite et de type P ou de type N, par voie humide, avant cristallisation de la pérovskite ledit empilement présentant une architecture planaire.

2. Empilement multicouche selon la revendication précédente, dans lequel ledit matériau pérovskite et ledit matériau de type P ou de type N forment, au sein de ladite couche composite, ladite structure interpénétrée sur une épaisseur comprise entre 10 et 150 nm..

3. Empilement multicouche selon la revendication 1 ou 2, dans lequel ladite couche composite présente, dans le sens de l'interface entre ladite couche composite et la couche semi-conductrice sous-jacente vers la face de ladite couche composite, opposée à l'interface entre la couche composite et la couche semi-conductrice sous-jacente :
- une première zone formée majoritairement du matériau de type pérovskite, voire exclusivement constituée du matériau de type pérovskite ;
- une zone comprenant un mélange des matériaux pérovskite et de type P dans le cas d'une structure NIP ou de type N dans le cas d'une structure PIN ; et
- une zone formée majoritairement, voire exclusivement constituée, du matériau de type P dans le cas d'une structure NIP ou de type N dans le cas d'une structure PIN.

4. Empilement multicouche selon l'une quelconque des revendications précédentes, ledit empilement ne mettant pas en oeuvre de couche à base de matériau mésoporeux.

5. Empilement multicouche selon l'une quelconque des revendications précédentes, dans lequel ladite couche composite présente une épaisseur inférieure ou égale à 1 µm, en particulier comprise entre 200 et 800 nm et plus particulièrement comprise entre 300 et 600 nm.

6. Empilement multicouche selon l'une quelconque des revendications précédentes, dans lequel le matériau pérovskite de ladite couche composite est de formule ABX₃, avec :
. A représentant un cation ou une combinaison de cations métalliques ou organiques ;
. B représentant un ou plusieurs éléments métalliques, tels que le plomb, l'étain, le bismuth et l'antimoine ; et
. X représentant un ou plusieurs anions, en particulier un ou plusieurs halogénures, et plus particulièrement choisis parmi le chlorure, le bromure, l'iodure et leurs mélanges ;
ledit matériau pérovskite étant en particulier de formule CsₓFA₁₋ₓPb(I_{1-y}Br_{y})₃ avec x < 0,17 ; 0 < y < 1 et FA symbolisant le cation formamidinium.

7. Empilement multicouche selon l'une quelconque des revendications précédentes, ledit empilement étant :
- de structure NIP, dans lequel le matériau de type P de ladite couche composite est choisi parmi des polymères semi-conducteurs π-conjugués, éventuellement dopés, les polymères conducteurs de type PEDOT sous une forme combinée à un contre-anion, tel que le PEDOT :PSS, et les molécules semi-conductrices de type P, en particulier celles à noyau(x) triphénylamine ; en particulier ledit matériau de type P est choisi parmi un mélange de PEDOT et de PSS, le poly[bis(4-phényl)(2,4,6-triméthylphényl)amine] (PTAA), éventuellement dopé avec un sel de lithium et/ou la 4-tert-butylpyridine, et le (E,E)-1,4-bis[2-[4-[N,N-bis(4-méthoxyphényl)amino]phényl]vinyl]benzène ; ou
- de structure PIN, dans lequel le matériau de type N de ladite couche composite est choisi parmi les oxyde(s) métallique(s) de type N, en particulier choisis parmi l'oxyde de zinc ZnO, les oxydes de titane TiOₓ avec x compris entre 1 et 2, l'oxyde d'étain (SnO₂), les oxydes de zinc dopés, par exemple l'oxyde de zinc dopé à l'aluminium (AZO), l'oxyde de zinc dopé à l'indium (IZO), l'oxyde de zinc dopé au gallium (GZO), les oxydes de titane dopés, par exemple l'oxyde de titane dopé à l'azote, au phosphore, au fer, au tungstène ou au manganèse, les oxydes d'étain dopés par exemple au fluor, et leurs mélanges ; et plus particulièrement parmi l'oxyde d'étain (SnO₂), les oxydes de zinc dopés, en particulier l'oxyde de zinc dopé à l'aluminium (AZO) et leurs mélanges.

8. Procédé de préparation d'un empilement multicouche défini selon l'une quelconque des revendications 1 à 7, comprenant au moins les étapes consécutives suivantes :
(a) disposer d'une structure présentant, en surface, une couche semi-conductrice de type N, dans le cas de la formation d'un empilement de structure NIP, ou de type P dans le cas de la formation d'un empilement de structure PIN,
(b) former, en surface de ladite couche conductrice de type N ou de type P, un film humide à partir d'une solution de précurseurs du matériau pérovskite dans un ou plusieurs solvants ;
(c) ajouter audit film humide de l'étape (b) au moins un matériau de type P dans le cas de la formation d'un empilement NIP, et de type N dans le cas d'un empilement PIN ; et
(d) soumettre l'ensemble à un traitement thermique propice à l'élimination des solvants et à la cristallisation du matériau pérovskite.

9. Procédé selon la revendication précédente, dans lequel l'étape (c) est réalisée par dépôt, en surface dudit film humide de l'étape (b), d'une formulation d'au moins un matériau de type P dans le cas de la formation d'un empilement NIP, dite encore « encre de type P », ou de type N dans le cas de la formation d'un empilement PIN, dite encore « encre de type N », dans un ou plusieurs solvants, dits « anti-solvants », dans lesquels les précurseurs de pérovskite ne sont pas solubles.

10. Procédé selon la revendication 8 ou 9, dans lequel les étapes (b) et (c) sont réalisées par dépôt à la tournette, de préférence l'étape (c) étant réalisée sans stopper la rotation du plateau tournant du dispositif de spin-coating.

11. Procédé selon l'une quelconque des revendications 8 à 10, dans lequel le ou lesdits solvants de la solution de précurseurs de pérovskite sont choisis parmi le diméthylformamide, le diméthylsulfoxyde, la gamma-butyrolactone et leurs mélanges.

12. Procédé selon l'une quelconque des revendications 9 à 11, dans lequel le ou lesdits anti-solvants de l'encre de type P ou de type N sont choisis parmi le diéthyléther ; le dichlorométhane; des composés aromatiques à un, deux ou trois cycles, substitués, en particulier substitués par un ou plusieurs groupements alkyles, notamment méthyle, et/ou halogène, en particulier chlore, tels que le toluène, le chlorobenzène, le xylène, le méthylnaphtalène ; et leurs mélanges.

13. Procédé selon l'une quelconque des revendications 8 à 12, dans lequel l'étape (d) est opérée par recuit thermique à une température comprise entre 60 et 150 °C, en particulier entre 80 et 120 °C, notamment pendant une durée comprise entre 5 et 120 minutes, notamment entre 15 et 90 minutes et plus particulièrement entre 30 et 60 minutes.

14. Dispositif photovoltaïque comportant au moins un empilement multicouche défini selon l'une quelconque des revendications 1 à 7 ou obtenu par un procédé défini selon l'une quelconque des revendications 8 à 13.

15. Dispositif photovoltaïque selon la revendication précédente, ledit dispositif étant une cellule photovoltaïque pérovskite en structure NIP ou PIN, de préférence en structure NIP, ou une cellule photovoltaïque de type multijonction, en particulier de type tandem.

16. Dispositif photovoltaïque selon la revendication précédente, ledit dispositif étant une cellule photovoltaïque pérovskite en structure NIP (23) ou PIN (24), et comportant dans cet ordre de superposition, au moins :
- un substrat (11), en particulier transparent, souple ou rigide, tel qu'un substrat en verre ou en matière plastique, notamment en PET ;
- une première électrode, dite électrode inférieure (12) ;
- un empilement multicouche défini selon l'une quelconque des revendications 1 à 7, formé de ladite couche semi-conductrice inférieure et de ladite couche composite ; et
- une deuxième électrode, dite électrode supérieure (16).

17. Dispositif photovoltaïque selon la revendication 15, ledit dispositif étant une cellule photovoltaïque de type tandem (26), comportant une première sous-cellule, notamment à base de silicium cristallin, sur laquelle est empilée une sous-cellule à base de pérovskite comprenant, dans cet ordre de superposition, au moins :
- un empilement multicouche défini selon l'une quelconque des revendications 1 à 7, formé de ladite couche semi-conductrice inférieure et de ladite couche composite ; et
- une électrode supérieure transparente, en particulier en oxyde conducteur transparent (TCO).

## Patentansprüche

1. Mehrschichtstapel zum Bilden einer Photovoltaikvorrichtung mit NIP- oder PIN-Struktur, wobei der Stapel eine planare Architektur aufweist und mindestens umfasst:
- eine halbleitende Schicht, untere halbleitende Schicht genannt, vom N-Typ (13) im Fall einer NIP-Struktur oder vom P-Typ (15) im Fall einer PIN-Struktur; und
- eine Verbundschicht, die der unteren leitenden Schicht überlagert ist und die mindestens ein Perowskit-Material und mindestens ein Material vom P-Typ im Fall einer NIP-Struktur (17) oder vom N-Typ im Fall einer PIN-Struktur (18) umfasst und einen Gradienten des Massenverhältnisses P-Material/Perowskit-Material im Fall einer NIP-Struktur oder N-Material/Perowskit-Material im Fall einer PIN-Struktur in Richtung der Grenzfläche zwischen der Verbundschicht und der unteren halbleitenden Schicht zu der entgegengesetzten Seite der Verbundschicht hin aufweist;
wobei das Perowskit-Material und das P-Typ- oder N-Typ-Material in der Verbundschicht, über eine Dicke von mindestens 10 nm, eine wechselseitig durchdrungene Struktur bilden, wobei die wechselseitig durchdrungene Struktur aus einer Matrix auf Basis des P-Typ- oder N-Typ-Materials gebildet wird, in die kristallisierte Perowskit-Bereiche eingebunden sind, und
wobei die Verbundschicht durch aufeinander folgendes nasschemisches Aufbringen der Perowskit- und P-Typ- oder vom N-Typ-Materialien gebildet wird, wobei der Stapel vor der Kristallisation des Perowskits eine planare Architektur aufweist.

2. Mehrschichtstapel nach dem vorhergehenden Anspruch, bei dem das Perowskit-Material und das P-Typ- oder N-Typ-Material in der Verbundschicht die wechselseitig durchdrungene Struktur über eine Dicke zwischen 10 und 150 nm bilden.

3. Mehrschichtstapel nach Anspruch 1 oder 2, bei dem die Verbundschicht in Richtung der Grenzfläche zwischen der Verbundschicht und der darunter liegenden halbleitenden Schicht zu der Seite der Verbundschicht hin, die zu der Grenzfläche zwischen der Verbundschicht und der darunter liegenden halbleitenden Schicht entgegengesetzt ist, aufweist:
- einen ersten Bereich, der mehrheitlich aus Perowskit-Typ-Material gebildet ist oder sogar ausschließlich aus dem Perowskit-Typ-Material besteht;
- einen Bereich, der eine Mischung aus den Perowskit-Materialien und den P-Typ-Materialien Fall einer NIP-Struktur oder N-Typ-Materialien im Fall einer PIN-Struktur umfasst; und
- einen Bereich, der mehrheitlich aus P-Typ-Material im Fall einer NIP-Struktur oder N-Typ-Material im Fall einer PIN-Struktur umfasst oder sogar ausschließlich daraus besteht.

4. Mehrschichtstapel nach einem der vorhergehenden Ansprüche, wobei der Stapel keine Schicht auf Basis von mesoporösem Material einsetzt.

5. Mehrschichtstapel nach einem der vorhergehenden Ansprüche, bei dem die Verbundschicht eine Dicke kleiner oder gleich 1 µm, bevorzugt zwischen 200 und 800 nm und noch bevorzugter 300 und 600 nm aufweist.

6. Mehrschichtstapel nach einem der vorhergehenden Ansprüche, bei dem das Perowskit-Material der Verbundschicht die Formel ABX₃ hat, worin:
. A für ein Kation oder eine Kombination aus metallischen oder organischen Kationen steht;
. B für ein oder mehrere metallische Elemente wie Blei, Zinn, Bismut und Antimon steht; und
. X für ein oder mehrere Anionen, bevorzugt ein oder mehrere Halogenide und besonders bevorzugt für unter Chlorid, Bromid, Iodid und ihren Mischungen ausgewählte steht;
wobei das Perowskit-Material insbesondere die Formel CsₓFA₁₋ₓPb(I_{1-y}Br_{y})₃ hat, worin x < 0,17; 0 < y < 1 und FA das Kation Formamidinium symbolisiert.

7. Mehrschichtstapel nach einem der vorhergehenden Ansprüche, wobei der Stapel:
- die Struktur NIP hat, in der das P-Typ-Material der Verbundschicht unter n-konjugierten, gegebenenfalls dotierten, halbleitenden Polymeren, leitenden Polymeren vom PEDOT-Typ in einer mit einem Gegenanion kombinierten Form wie dem PEDOT :PSS und den halbleitenden P-Typ-Molekülen, bevorzugt denen mit Triphenylamin-Kern(en), gewählt ist; das P-Typ-Material bevorzugt unter einer Mischung von PEDOT und PSS, dem Poly[bis (4-phenyl) (2,4,6-trimethylphenyl)amin] (PTAA), gegebenenfalls mit einem Lithiumsalz und/oder dem 4-tert-Butylpyridin dotiert, und dem (E,E)-1,4-bis[2-[4-[N,N-bis(4-Methoxyphenyl)amino]phenyl]vinyl]benzol gewählt ist; oder
- die Struktur PIN hat, in der das N-Typ-Material der Verbundschicht unter dem(den) N-Typ-Metalloxid(en) gewählt ist, die bevorzugt unter dem Zinkoxid ZnO, den Titanoxiden TiOₓ mit x zwischen 1 und 2, dem Zinnoxid (SnO₂), den dotierten Zinkoxiden, zum Beispiel dem aluminiumdotierten Zinkoxid (AZO), dem indiumdotierten Zinkoxid (IZO), dem galliumdotierten Zinkoxid (GZO), den dotierten Titanoxiden, zum Beispiel dem stickstoff-, phosphor-, eisen-, wolfram- oder mangandotierten Titanoxid, den zum Beispiel fluordotierten Zinnoxiden und ihren Mischungen; und besonders bevorzugt unter dem Zinnoxid (SnO₂), den dotierten Zinkoxiden, bevorzugt dem aluminiumdotierten Zinkoxid (AZO), und ihren Mischungen gewählt sind.

8. Verfahren zum Herstellen eines gemäß einem der Ansprüche 1 bis 7 definierten Mehrschichtstapels, umfassend mindestens die folgenden aufeinander folgenden Schritte:
(a) Bereitstellen einer Struktur, die, an der Oberfläche, eine halbleitende N-Typ-Schicht im Fall der Bildung eines Stapels mit NIP-Struktur oder eine P-Typ-Schicht im Fall der Bildung eines Stapels mit PIN-Struktur aufweist,
(b) Bilden, an der Oberfläche der leitenden N-Typ- oder P-Typ-Schicht, eines nassen Films ausgehend von einer Lösung von Vorläufern des Perowskit-Materials in einem oder mehreren Lösemitteln;
(c) Zugeben, zu dem nassen Film des Schritts (b), mindestens eines P-Typ-Materials im Fall der Bildung eines NIP-Stapels oder N-Typ-Materials im Fall eines PIN-Stapels; und
(d) Unterziehen des Ganzen einer Wärmebehandlung, die zur Beseitigung der Lösemittel und zur Kristallisation des Perowskit-Materials günstig ist.

9. Verfahren nach dem vorhergehenden Anspruch, bei dem der Schritt (c) durch Aufbringen, an der Oberfläche des nassen Films des Schritts (b), einer Zusammensetzung aus mindestens einem P-Typ-Material im Fall der Bildung eines NIP-Stapels, auch "P-Typ-Tinte" genannt, oder einem N-Typ-Material im Fall der Bildung eines PIN-Stapels, auch "N-Typ-Tinte" genannt, in einem oder mehreren Lösemitteln, "Anti-Lösemittel" genannt, in denen die Perowskit-Vorläufer nicht löslich sind, ausgeführt wird.

10. Verfahren nach Anspruch 8 oder 9, bei dem die Schritte (b) und (c) durch Aufbringen mit dem Rotationsbeschichter ausgeführt werden, wobei der Schritt (c) vorzugsweise ausgeführt wird, ohne die Drehung des Drehtellers der Spin-Coating-Vorrichtung zu stoppen.

11. Verfahren nach einem der Ansprüche 8 bis 10, bei dem das oder die Lösemittel der Perowskit-Vorläufer-Lösung unter dem Dimethylformamid, dem Dimethylsulfoxid, dem Gamma-Butyrolacton und ihren Mischungen gewählt sind.

12. Verfahren nach einem der Ansprüche 9 bis 11, bei dem das oder die Anti-Lösemittel der P-Typ- oder N-Typ-Tinte unter dem Diethylether; dem Dichlormethan; aromatischen Verbindungen mit einem, zwei oder drei Ringen, die substituiert sind, bevorzugt durch ein oder mehrere Alkylgruppen, insbesondere Methyl, und/oder Halogen, bevorzugt Chlor, substituiert sind, wie Toluol, Chlorbenzol, Xylol, Methylnaphtalen; und ihren Mischungen gewählt sind.

13. Verfahren nach einem der Ansprüche 8 bis 12, bei dem der Schritt (d) durch thermisches Glühen bei einer Temperatur zwischen 60 und 150 °C, bevorzugt zwischen 80 und 120 °C, insbesondere während einer Dauer zwischen 5 und 120 Minuten, insbesondere zwischen 15 und 90 Minuten und besonders bevorzugt zwischen 30 und 60 Minuten durchgeführt wird.

14. Photovoltaikvorrichtung, die mindestens einen gemäß einem der Ansprüche 1 bis 7 definierten oder mit einem gemäß einem der Ansprüche 8 bis 13 definieren Verfahren hergestellten Mehrschichtstapel beinhaltet.

15. Photovoltaikvorrichtung nach dem vorhergehenden Anspruch, wobei die Vorrichtung eine Perowskit-Photovoltaikzelle mit NIP- oder PIN-Struktur, vorzugsweise mit NIP-Struktur, oder eine Mehrfach-, bevorzugt eine Tandemphotovoltaikzelle ist.

16. Photovoltaikvorrichtung nach dem vorhergehenden Anspruch, wobei die Vorrichtung eine Perowskit-Photovoltaikzelle mit NIP- (23) oder PIN-Struktur (24) ist und in dieser Überlagerungsreihenfolge mindestens beinhaltet:
- ein Substrat (11), insbesondere transparent, flexibel oder starr, wie etwa ein Substrat aus Glas oder aus Kunststoff, insbesondere aus PET;
- eine erste Elektrode, untere Elektrode (12) genannt;
- einen gemäß einem der Ansprüche 1 bis 7 definierten Mehrschichtstapel, der aus der unteren halbleitenden Schicht und der Verbundschicht gebildet wird; und
- eine zweite Elektrode, obere Elektrode (16) genannt.

17. Photovoltaikvorrichtung nach Anspruch 15, wobei die Vorrichtung eine Tandemphotovoltaikzelle (26) ist, die eine erste Unterzelle beinhaltet, insbesondere auf Basis von kristallinem Silicium, auf die eine Unterzelle auf Basis von Perowskit gestapelt ist, umfassend, in dieser Überlagerungsreihenfolge, mindestens:
- einen gemäß einem der Ansprüche 1 bis 7 definierten Mehrschichtstapel, der aus der unteren halbleitenden Schicht und der Verbundschicht gebildet wird; und
- eine transparente obere Elektrode, insbesondere aus transparentem leitendem Oxid (TCO).

## Claims

1. Multilayer stack, of use in forming a photovoltaic device, of NIP or PIN structure, said stack having a planar architecture and comprising at least:
- a semiconductor layer, referred to as lower semiconductor layer, of N type (13) in the case of an NIP structure, or of P type (15) in the case of a PIN structure; and
- a composite layer, superposed on said lower conductive layer, comprising at least one perovskite material and at least one P-type material in the case of an NIP structure (17) or of N type in the case of a PIN structure (18), and having a gradient of the P material/perovskite material weight ratio in the case of an NIP structure or N material/perovskite material weight ratio in the case of a PIN structure, in the direction from the interface between said composite layer and said lower semiconductor layer towards the opposite face of said composite layer;
said perovskite material and said P-type or N-type material forming within said composite layer, over a thickness of at least 10 nm, an interpenetrated structure, said interpenetrated structure being formed of a matrix based on said P-type or N-type material, in which crystalline perovskite domains are incorporated, and
said composite layer being formed by successive wet deposition of said perovskite and P-type or N-type materials, before crystallization of the perovskite, said stack having a planar architecture.

2. Multilayer stack according to the preceding claim, in which said perovskite material and said P-type or N-type material form, within said composite layer, said interpenetrated structure over a thickness of between 10 and 150 nm.

3. Multilayer stack according to Claim 1 or 2, in which said composite layer has, in the direction from the interface between said composite layer and the underlying semiconductor layer, towards the face of said composite layer which is on the opposite side to the interface between the composite layer and the underlying semiconductor layer:
- a first zone formed predominantly of the perovskite material, or even exclusively constituted of the perovskite material;
- a zone comprising a mixture of perovskite and P-type materials in the case of an NIP structure or perovskite and N-type materials in the case of a PIN structure; and
- a zone formed predominantly, or even exclusively constituted, of P-type material in the case of an NIP structure or of N-type material in the case of a PIN structure.

4. Multilayer stack according to any one of the preceding claims, said stack not using a layer based on miso porous material.

5. Multilayer stack according to any one of the preceding claims, in which said composite layer has a thickness of less than or equal to 1 µm, in particular between 200 and 800 nm and more particularly between 300 and 600 nm.

6. Multilayer stack according to anyone of the preceding claims, in which the perovskite material of said composite layer is of formula ABX₃, with:
. A representing a cation or a combination of metal or organic cations;
. B representing one or more metal elements, such as lead, tin, bismuth and antimony; and
. X representing one or more anions, in particular one or more halides, and more particularly chosen from chloride, bromide, iodide and mixtures thereof;
said perovskite material being in particular of formula CsₓFA₁₋ₓPb(I_{1-y}Br_{y})₃ with x < 0.17; 0 < y < 1 and FA standing for the formamidinium cation.

7. Multilayer stack according to any one of the preceding claims, said stack being:
- of NIP structure, in which the P-type material of said composite layer is chosen from π-conjugated semiconducting polymers, which are optionally doped, conductive polymers of PEDOT type in a form combined with a counteranion, such as PEDOT :PSS, and P-type semiconducting molecules, in particular those with triphenylamine core(s); in particular said P-type material is chosen from a mixture of PEDOT and PSS, poly[bis(4-phenyl)(2,4,6-trimethylphenyl)amine] (PTAA), optionally doped with a lithium salt and/or 4-tert-butylpyridine, and (E,E)-1,4-bis[2-[4-[N,N-bis(4-methoxyphenyl)amino]phenyl]vinyl]benzene; or
- of PIN structure, in which the N-type material of said composite layer is chosen from N-type metal oxide(s), in particular chosen from zinc oxide ZnO, titanium oxides TiOₓ with x between 1 and 2, tin oxide (SnO₂), doped zinc oxides, for example aluminium-doped zinc oxide (AZO), indium-doped zinc oxide (IZO), gallium-doped zinc oxide (GZO), doped titanium oxides, for example titanium oxide doped with nitrogen, phosphorus, iron, tungsten or manganese, tin oxide doped for example with fluorine, and mixtures thereof; and more particularly from (SnO₂), doped zinc oxides, in particular aluminium-doped zinc oxide (AZO) and mixtures thereof.

8. Process for preparing a multilayer stack defined according to any one of Claims 1 to 7, comprising at least the following consecutive steps:
(a) providing a structure having, on the surface, a semiconductor layer of N type, in the case of forming a stack of NIP structure, or of P type, in the case of forming a stack of PIN structure,
(b) forming, on the surface of said N-type or P-type conductive layer, a wet film from a solution of precursors of the perovskite material in one or more solvents;
(c) adding to said wet film from step (b) at least one material of P type in the case of forming an NIP stack, and of N type in the case of a PIN stack; and
(d) subjecting the assembly to a heat treatment suitable for eliminating the solvents and for crystallizing the perovskite material.

9. Process according to the preceding claim, in which step (c) is carried out by depositing, on the surface of said wet film from step (b), a formulation of at least one material of P-type in the case of forming an NIP stack, also referred to as "P-type ink", or of N type in the case of forming a PIN stack, also referred to as "N-type ink", in one or more solvents, referred to as "anti-solvents" in which the perovskite precursors are not soluble.

10. Process according to Claim 8 or 9, in which steps (b) and (c) are carried out by spin coating, preferably step (c) being carried out without stopping the rotation of the spinning plate of the spin-coating device.

11. Process according to any one of Claims 8 to 10, in which said solvent(s) of the solution of perovskite precursors is/are chosen from dimethylformamide, dimethyl sulfoxide, gamma-butyrolactone and mixtures thereof.

12. Process according to any one of Claims 9 to 11, in which said anti-solvent (s) of the P-type ink or N-type ink is/are chosen from diethyl ether; dichloromethane; aromatic compounds with one, two or three rings, which are substituted, in particular substituted with one or more alkyl groups, notably methyl, and/or a halogen, in particular chlorine, such as toluene, chlorobenzene, xylene, methylnaphthalene; and mixtures thereof.

13. Process according to any one of Claims 8 to 12, in which step (d) is carried out by thermal annealing at a temperature between 60°C and 150°C, in particular between 80°C and 120°C, notably for a duration of between 5 and 120 minutes, notably between 15 and 90 minutes and more particularly between 30 and 60 minutes.

14. Photovoltaic device comprising at least one multilayer stack defined according to any one of Claims 1 to 7 or obtained by a process defined according to any one of Claims 8 to 13.

15. Photovoltaic device according to the preceding claim, said device being a perovskite photovoltaic cell of NIP or PIN structure, preferably of NIP structure, or a multi-junction photovoltaic cell, in particular a tandem photovoltaic cell.

16. Photovoltaic device according to the preceding claim, said device being a perovskite photovoltaic cell of NIP structure (23) or PIN structure (24), and having, in this order of superposition, at least:
- a substrate (11), in particular which is transparent, flexible or rigid, such as a substrate made of glass or of plastic, notably of PET;
- a first electrode, referred to as bottom electrode (12) ;
- a multilayer stack defined according to any one of Claims 1 to 7, formed of said lower semiconducting layer and of said composite layer; and
- a second electrode, referred to as top electrode (16) .

17. Photovoltaic device according to Claim 15, said device being a tandem photovoltaic cell (26), comprising a first subcell, notably based on crystalline silicon, on which is stacked a perovskite-based subcell comprising, in this order of superposition, at least:
- a multilayer stack defined according to any one of Claims 1 to 7, formed of said lower semiconducting layer and of said composite layer; and
- a transparent top electrode, in particular made of transparent conductive oxide (TCO).
